# EUROPÄISCHE PATENTSCHRIFT

(11) **EP 3 747 655 B1**
(45) Veröffentlichungstag und Bekanntmachung des Hinweises auf die Patenterteilung: **28.09.2022**
(21) Anmeldenummer: 20177800.8
(22) Anmeldetag: 02.06.2020
(51) Int. Cl.: B41J 2/03, B41J 2/005, H01L 31/18, H05K 3/12

(54) **DRUCKKOPF UND VERFAHREN ZUR HERSTELLUNG EINES DRUCKKOPFS**
PUSH BUTTON AND METHOD FOR PRODUCING A PUSH BUTTON
TÊTE D'IMPRESSION ET PROCÉDÉ DE FABRICATION D'UNE TÊTE D'IMPRESSION

(30) Priorität: 04.06.2019 DE 102019115009
(43) Veröffentlichungstag der Anmeldung: 09.12.2020
(73) Patentinhaber: Fraunhofer-Gesellschaft zur Förderung der angewandten Forschung e.V., 80686 München (DE)
(72) Erfinder: KUCHLER, Martin, 79110 Freiburg (DE); TEPNER, Sebastian, 79110 Freiburg (DE); KLAWITTER, Markus, 79110 Freiburg (DE); BREITENBÜCHER, Marian, 79110 Freiburg (DE); RIEBE, Tim, 79110 Freiburg (DE); POSPISCHIL, Maximilian, 79110 Freiburg (DE)
(74) Vertreter: LBP Lemcke, Brommer & Partner Patentanwälte mbB

(56) Entgegenhaltungen:
- EP-A1- 2 620 286
- EP-A2- 3 456 537
- US-A1- 2012 050 428

## Beschreibung

Die Erfindung betrifft einen Druckkopf zum Parallelextrudieren von Druckmedium gemäß Anspruch 1 sowie ein Verfahren zur Herstellung eines Druckkopfes gemäß Anspruch 13.

Bei industriellen Druckvorgängen, insbesondere bei der Herstellung von Halbleiterstrukturen, wie beispielsweise fotovoltaischen Solarzellen, ist es häufig wünschenswert, ein Druckmedium in mehreren parallelen Bahnen auf das Substrat aufzubringen. Solch ein Druckmedium kann eine Druckpaste sein, welche insbesondere einen Dotierstoff zur Dotierung eines oder mehrerer Bereiche der Halbleiterstruktur enthält, welche zur Ausbildung einer Maskierung für nachfolgende Prozessschritte dient und/oder welche Metallpartikel zum Ausbilden einer metallischen Kontaktstruktur enthält.

Aus DE 10 2013 223 250 A1 ist ein Druckkopf zum Aufbringen mehrerer paralleler Druckmedienlinien auf ein Substrat bekannt.

Aus US 2012 / 0050428 A1 ist ebenfalls ein Druckkopf zum Aufbringen mehrerer paralleler Druckmedienlinien auf ein Substrat bekannt. Ein Filter ist in Flussrichtung des Druckmediums vor einer Vielzahl an Auslassöffnungen angeordnet. Die Aus EP 3 456 537 A2 ist ein Druckkopf bekannt, welcher drei Gehäusekomponenten und zwei Filter umfasst. Die Filter sind jeweils zwischen zwei Gehäusekomponenten angeordnet.

Bei vielen Anwendungen ist eine hohe Präzision der aufgebrachten Drucklinien, insbesondere eine genaue Definition des Start- und Endpunkts der Drucklinien wünschenswert. Weiterhin ist es für viele Anwendungen wünschenswert, feine Linien zu drucken, sodass die entsprechenden Auslassöffnungen des Druckkopfes einen geringen Durchmesser aufweisen.

Solche Druckköpfe sind anfällig für Störungen aufgrund von Schmutzpartikeln, welche den Druckmediumfluss beeinträchtigen. Insbesondere ist die Auslassöffnungen solche Druckköpfe sind anfällig für ein teilweises oder vollständiges Versperren durch große Partikel wie z.B. Schmutzpartikel.

Der vorliegenden Erfindung liegt daher die Aufgabe zugrunde, das Risiko einer Beeinträchtigung des Flussweges des Druckmediums aufgrund von Partikeln zu verringern. Gelöst ist diese Aufgabe durch einen Druckkopf zum Parallelextrudieren von Druckmedium gemäß Anspruch 1 sowie durch ein Verfahren zur Herstellung eines Druckkopfes gemäß Anspruch 13. . Vorteilhafte Ausgestaltungen finden sich in den abhängigen Unteransprüchen.

Der erfindungsgemäße Druckkopf ist bevorzugt mittels des erfindungsgemäßen Verfahrens, insbesondere einer bevorzugten Ausführungsform hiervon, hergestellt. Das erfindungsgemäße Verfahren ist bevorzugt zum Herstellen eines erfindungsgemäßen Druckkopfes, insbesondere einer vorteilhaften Ausführungsform hiervon, ausgebildet.

Der erfindungsgemäße Druckkopf zum Parallelextrudieren von Druckmedium, insbesondere zur Herstellung von Leiterbahnen, weist einen Druckmediumeingang für das Druckmedium, welcher fluidleitend mit einer Mehrzahl von Ausgabeöffnungen des Druckkopfes verbunden ist, zur gleichzeitigen Ausgabe von Druckmedium aus den Ausgabeöffnungen auf. Weiterhin weist der Druckkopf ein Aufweitungselement auf, welches im Flussweg des Druckmediums zwischen Druckmediumeingang und Ausgabeöffnungen angeordnet ist, um den Durchflussquerschnitt in Flussrichtung des Druckmediums auf ein Aspektverhältnis von zumindest 3:1, bevorzugt zumindest 5:1, insbesondere zumindest 8:1 aufzuweiten.

Das Aufweitungselement ermöglicht somit das Einspeisen von Druckmedium, insbesondere bei in einer geraden Linie angeordneten Ausgabeöffnungen. Der erfindungsgemäße Druckkopf weist weiterhin eine Basiseinheit mit dem Druckmediumeingang und dem Aufweitungselement und eine lösbar an der Basiseinheit angeordnete Ausgabeeinheit auf. Die Ausgabeeinheit weist die Mehrzahl von Ausgabeöffnungen und zumindest einen Ausgabefilter für das Druckmedium auf, wobei im Betriebszustand bei an der Basis angeordneter Ausgabeeinheit der Ausgabefilter im Flussweg des Druckmediums zwischen Druckmediumeingang und Ausgabeöffnungen angeordnet ist.

Die Erfindung ist in der Erkenntnis begründet, dass insbesondere bei den Ausgabeöffnungen ein hohes Risiko besteht, dass diese durch Partikel, insbesondere durch Fremdpartikel zugesetzt werden und somit kein oder zumindest ein verringerter Durchfluss von Druckmedium erfolgt. Die Erfahrungen des Anmelders zeigen weiterhin, dass bei Einbau und Wartung des Druckkopfes häufig die Anforderungen an eine saubere, von Schmutzpartikeln freie Umgebung nicht eingehalten werden und somit insbesondere bei Austausch oder Reparatur eines Druckkopfes am Ort einer Druckvorrichtung ein hohes Risiko besteht, dass Schmutzpartikel in den Druckkopf und insbesondere in den Bereich der Ausgabeöffnungen gelangen.

Die vorliegende Erfindung vermeidet oder verringert zumindest dieses Risiko, da die lösbar an der Basiseinheit angeordnete Ausgabeeinheit einen Ausgabefilter vorweist, welcher im Betriebszustand im Flusswegs des Druckmediums zwischen Druckmediumeingang und Ausgabeöffnung angeordnet ist. Die vorliegende Erfindung eröffnet somit die Möglichkeit, den Zusammenbau der Ausgabeeinheit an einem Ort mit niedriger Schmutzkontamination durchzuführen, sodass nur ein geringes Risiko besteht, dass sich Fremdpartikel zwischen Ausgabefilter und Ausgabeöffnungen befinden. Wird nun die Ausgabeeinheit am Anwendungsort an die Basiseinheit angeordnet, so besteht kein oder zumindest ein erheblich geringeres Risiko, dass Schmutzpartikel zwischen Filter und Ausgabeöffnungen gelangen, da die Schmutzpartikel durch den Filter oder durch die Ausgabeöffnungen (im Betriebszustand entgegen dem Flussweg des Druckmediums) in die Ausgabeeinheit gelangen müssten.

Etwaige Schmutzpartikel, welche bei Zusammenbau bzw. Wartung zwischen Basiseinheit und Ausgabeeinheit gelangen, können im Betriebszustand durch den Filter aufgehalten werden, sodass das Risiko eines Zusetzens der Ausgabeöffnungen vermieden oder zumindest erheblich verringert wird.

Erfindungsgemäß weist der Druckkopf zumindest einen weiteren Filter auf: Der Druckkopf weist einen Basisfilter und/oder einen Vorfilter auf.

Wenn der Druckkopf einen Basisfilter aufweist, ist der Basisfilter derart an der Basiseinheit angeordnet, dass im Betriebszustand der Basisfilter im Flussweg des Druckmediums zwischen Druckmediumeingang und Ausgabefilter angeordnet ist. Hierdurch erfolgt eine Vorfilterung, welche insbesondere ein schnelles Zusetzen des Ausgabefilters vermeidet. Insbesondere ist es daher vorteilhaft, dass die Maschengröße des Basisfilters größer als die Maschengröße des Ausgabefilters ist.

Wenn der Druckkopf einen Vorfilter aufweist, ist der Vorfilter derart an der Ausgabeeinheit angeordnet, dass im Betriebszustand der Vorfilter im Flussweg des Druckmediums vor dem Ausgabefilter angeordnet ist. Der Vorfilter bietet eine zusätzliche Möglichkeit, Fremdpartikel zu filtern. Insbesondere weist der Ausgabefilter bevorzugt eine kleinere Maschengröße als der Vorfilter auf, sodass größere Fremdpartikel von dem Vorfilter, kleinere Fremdpartikel jedoch von dem Ausgabefilter gefiltert werden.

In einer vorteilhaften Weiterbildung des erfindungsgemäßen Druckkopfs wird das Risiko des Zusetzens der Ausgabeöffnungen weiter verringert, indem der Ausgabefilter eine mittlere Maschengröße aufweist, welche kleiner als die Hälfte, bevorzugt kleiner als ein Viertel des mittleren Durchmessers der Ausgabeöffnungen ist.

In einer weiteren vorteilhaften Weiterbildung ist der Filter an der Ausgabeeinheit fixiert. Hierdurch wird vermieden, dass bei Einbau- oder Wartungsarbeiten durch den Benutzer der Filter aus der Ausgabeeinheit entfernt wird und somit Schmutzpartikel in einem Bereich zwischen Filter und Ausgabeöffnungen der Ausgabeeinheit gelangen können. Die Fixierung kann durch Klemmen oder Schrauben erfolgen, insbesondere ist ein Fixierung mittels einer Fügeverbindung vorteilhaft.

Der Basisfilter ist bevorzugt im aufgeweiteten Bereich des Aufweitungselementes angeordnet. Hierdurch kann der Basisfilter eine größere Querschnittsfläche aufweisen.

In einer weiteren vorteilhaften Ausgestaltung ist die Ausgabeeinheit derart ausgebildet, dass sich der Durchflussquerschnitt in Flussrichtung des Druckmediums zwischen Ausgabefilter und Ausgabeöffnungen verringert. Zwischen Ausgabefilter und Ausgabeöffnungen ist somit bevorzugt ein Reduktionselement vorgesehen, welches den Durchflussquerschnitt in Flussrichtung ausgehend von dem Ausgabefilter verringert, bevor mit dem verringerten Durchflussquerschnitt das Druckmedium zu den Ausgabeöffnungen (die einen erheblich verringerten Durchflussquerschnitt aufweisen) gelangt.

Der Vorfilter ist bevorzugt zu dem Ausgabefilter beabstandet, insbesondere in Flussrichtung des Druckmediums beabstandet, bevorzugt mit einem Abstand im Bereich 0,5 mm bis 3 mm, insbesondere von 1 mm bis 2 mm. Hierdurch ergibt sich der Vorteil, dass in dem Raum zwischen Vorfilter und Ausgabefilter Fremdpartikel verbleiben können, welche zwar den Vorfilter, nicht jedoch den Ausgabefilter durchdringen. Durch das Beabstanden ist somit ein Auffangreservoir für solche Fremdpartikel gebildet.

Der Druckkopf weist bevorzugt einen Drucksensor für das Druckmedium auf. Hierdurch ist eine Kontrolle des im Druckkopf bestehenden Drucks möglich und ist kann mittels einer Steuereinheit ein vorgegebener Druck eingestellt und erhalten werden, sodass ein einheitliches Druckbild, insbesondere eine einheitliche Druckstärke der aufgebrachten Drucklinien erzielt wird.

Der Drucksensor ist bevorzugt im Flussweg des Druckmediums stromabwärts des Ausgabefilters angeordnet. Insbesondere ist es vorteilhaft, dass der Drucksensor im Flussweg des Druckmediums zwischen Ausgabefilter und Ausgabeöffnungen angeordnet ist. Der Druck des Druckmediums unmittelbar vor den Ausgabeöffnungen stellt einen wesentlichen Parameter dar, welcher das Druckbild, insbesondere die Dicke von aufgetragenen Druckmediumlinien beeinflusst. Daher ist es vorteilhaft, wie zuvor beschrieben, zwischen Ausgabefilter und Ausgabeöffnungen den Drucksensor anzuordnen. Die eingangs genannte Aufgabe ist weiterhin durch eine Druckvorrichtung zum Parallelextrudieren von Druckmedium gemäß Anspruch 10 gelöst, mit einem erfindungsgemäßen Drucckopf, insbesondere einem Druckkopf gemäß einer bevorzugten Ausführungsform, einer im Flussweg des Druckmediums stromaufwärts des Druckkopfes angeordneten Druckmediumpumpe, um Druckmedium aus einem Druckmediumreservoir zu dem Druckkopf zu fördern.

Der Druckkopf der Druckvorrichtung weist bevorzugt einen Drucksensor wie zuvor beschrieben auf und die Druckvorrichtung weist weiterhin bevorzugt eine Steuereinheit für die Druckmediumpumpe auf, welche mit dem Drucksensor zusammenwirkend ausgebildet ist, um die Druckmediumpumpe derart zu regeln, dass während des Druckvorgangs ein konstanter Druck am Drucksensor besteht.

Hierdurch werden die zuvor genannten Vorteile, insbesondere einer konstanten Druckmediumausgabe bzw. Liniendicke des ausgegebenen Druckmediums erzielt.

In einer vorteilhaften Weiterbildung weist die Druckvorrichtung zusätzlich zu dem vorgenannten Drucksensor als ersten Drucksensor zumindest einen weiteren Drucksensor als zweiten Drucksensor auf. Der erste Drucksensor ist im Flussweg des Druckmediums nach dem Ausgabefilter und der zweite Drucksensor ist im Flussweg des Druckmediums vor dem Ausgabefilter angeordnet. Hierdurch kann durch abhängig von einer Druckdifferenz am Ort des ersten und des zweiten Drucksensors der Verschmutzungsgrad des Ausgabefilters bestimmt werden. Bevorzugt weist die Druckvorrichtung daher eine Auswerteeinheit auf, welche mit erstem und zweitem Drucksensor verbunden ist und abhängig von einer Druckdifferenz zwischen den beiden Sensoren dem Benutzer den Verschmutzungsgrad und/oder ein Austauschen des Ausgabefilters signalisiert.

Vorteilhafterweise weist die Druckvorrichtung einen Eingangsfilter auf, welcher im Flussweg des Druckmediums vor dem Druckkopf angeordnet ist. Hierdurch können Fremdpartikel bereits am Eindringen in den Druckkopf gehindert werden. Insbesondere ist es vorteilhaft, dass der Eingangsfilter eine größere Maschengröße als der Ausgabefilter aufweist. Hierdurch ergibt sich der Vorteil, dass die Verwendungsdauer ("Standzeit") des Filters erhöht wird.

Die eingangs genannte Aufgabe ist weiterhin durch ein Verfahren zur Herstellung eines Druckkopfes, insbesondere eines erfindungsgemäßen Druckkopfes, bevorzugt einer vorteilhaften Ausführungsform hiervon, gelöst.

Das Verfahren dient zur Herstellung eines Druckkopfes mit einer Basiseinheit, wobei die Basiseinheit mit einem Druckmediumeingang für das Druckmedium ausgebildet wird, welcher fluidleitend mit einer Mehrzahl von Ausgabeöffnungen des Druckkopfes verbunden ist, zur gleichzeitigen Ausgabe von Druckmedium aus den Ausgabeöffnungen. Die Basiseinheit wird weiterhin mit einem Aufweitungselement ausgebildet, welches im Flussweg des Druckmediums zwischen Druckmediumeingang und Ausgabeöffnungen angeordnet ist, um den Durchflussquerschnitt in Flussrichtung des Druckmediums auf ein Aspektverhältnis von zumindest 3:1, bevorzugt zumindest 5:1, insbesondere zumindest 8:1, weiter bevorzugt zumindest 30:1 aufzuweiten.

Wesentlich ist, dass der Druckkopf mit einer lösbar an der Basiseinheit anordenbaren Ausgabeeinheit ausgebildet wird und dass ein Ausgabefilter an der Ausgabeeinheit im Flussweg des Druckmediums vor den Ausgabeöffnungen angeordnet wird, bevorzugt mittels einer Fügeverbindung.

Erfindungsgemäß wird zumindest ein weiterer Filter an dem Druckkopf angeordnet: Es wird ein Basisfilter und/oder ein Vorfilter an dem Druckkopf angeordnet.

Wenn der herzustellende Druckkopf einen Basisfilter aufweist, wird der Basisfilter derart an der Basiseinheit angeordnet, dass im Betriebszustand der Basisfilter im Flussweg des Druckmediums zwischen Druckmediumeingang und Ausgabefilter angeordnet ist. Insbesondere ist die Maschengröße des Basisfilters größer als die Maschengröße des Ausgabefilters.

Wenn der herzustellende Druckkopf einen Vorfilter aufweist, der Vorfilter derart an der Ausgabeeinheit angeordnet, dass im Betriebszustand der Vorfilter im Flussweg des Druckmediums vor dem Ausgabefilter angeordnet ist. Insbesondere weist der Ausgabefilter eine kleinere Maschengröße als der Vorfilter auf. Hier wird der bereits genannte Vorteil erzielt, dass aufgrund des bereits werksseitig an der Basiseinheit angeordneten Ausgabefilters dieser durch den Benutzers der Filter nicht von der Ausgabeeinheit gelöst werden muss und somit herstellerseitig ein Erzeugen der Ausgabeeinheit in einer fremdpartikelfreien oder zumindest fremdpartikelarmen Umgebung erfolgen kann und somit das Risiko, dass bei Anwendung durch den Benutzer Fremdpartikel zwischen Ausgabefilter und Ausgabeöffnungen gelangen, vermieden oder zumindest erheblich verringert wird. Dieses Risiko wird weiter verringert, indem der Ausgabefilter mittels Fügeverbindung an der Ausgabeeinheit angeordnet ist.

Vorteilhafterweise werden die Ausgabeöffnungen mittels einem lösbaren Schutzelement, insbesondere einer Schutzfolie, verschlossen. Das lösbare Schutzelement kann von dem Benutzer unmittelbar vor Starten des Druckvorgangs gelöst werden. Hierdurch wird vermieden, dass beim Transport und Einbau oder Wartung des Ausgabeelementes Fremdpartikel durch die Ausgabeöffnungen in den Bereich zwischen Ausgabefilter und Ausgabeöffnungen gelangen.

Vorteilhafterweise werden die Ausgabeöffnungen in einer Düsenschiene ausgebildet und die Düsenschiene mit den Ausgabeöffnungen wird mittels Fügeverbindung an der Ausgabeeinheit angeordnet.

Hierdurch ergibt sich der Vorteil, dass eine präzise Ausgestaltung der Ausgabeöffnungen in der Düsenschiene erfolgen kann und insbesondere ein Material geeigneter Härte, insbesondere ein hochfestes Material, für die Düsenschiene verwendet werden kann. Das Anbringen der Düsenschiene mittels einer Fügeverbindung an der Ausgabeöffnung verhindert ein benutzerseitiges Abnehmen der Düsenschiene von der Ausgabeeinheit und vermeidet somit ein Eindringen von Fremdpartikeln in die Ausgabeeinheit bei abgenommener Düsenschiene.

Der erfindungsgemäße Druckkopf wird bevorzugt zum Aufbringen paralleler Linien des Druckmediums auf ein Substrat verwendet. Hierbei ist es vorteilhaft, während des Druckvorgangs Druckkopf und Substrat relativ zueinander zu bewegen. Insbesondere zur Integration eines Inline-Prozesses ist es vorteilhaft, bei ortsfestem Druckkopf das Substrat relativ zu dem Druckkopf zu bewegen.

Der Druckkopf ist insbesondere zur Verwendung bei der Herstellung von Halbleiterbauelementen und hierbei insbesondere bei der Herstellung von fotovoltaischen Solarzellen einsetzbar. Insbesondere ist der Druckkopf geeignet, mit Dotierstoffen und/oder mit Halbpartikeln versehenes Druckmedium auf ein Substrat auszubilden, um Dotierbereiche und/oder metallische Kontaktierungsstrukturen auszubilden.

Ebenso liegen andere Verwendungen des Druckkopfes im Rahmen der Erfindung, insbesondere das Aufbringen anderer Druckmedien wie beispielsweise Klebstoffe, Farbe oder andere Wirkstoffe auf ein Substrat. Ebenso liegt die Verwendung des Druckkopfes zur Mikrodosierung von Druckmedium beispielsweise bei Einsatz in der Medizintechnik im Rahmen der Erfindung.

Es liegt im Rahmen der Erfindung, mittels des erfindungsgemäßen Druckkopfes kontinuierliche Bahnen von Druckmedium zu erzeugen. Ebenso liegt es im Rahmen der Erfindung, unterbrochene Bahnen, insbesondere kurze Liniensegmente, insbesondere Linien mit punktförmigen und/oder strichartigen Segmenten zu Erzeugen.

Weitere bevorzugte Merkmale und Ausführungsformen werden im Folgenden anhand eines Ausführungsbeispiels und den Figuren erläutert. Dabei zeigt:
- Figur 1: ein Ausführungsbeispiel eines erfindungsgemäßen Druckkopfes in Explosionsdarstellung;
- Figur 2: einen Querschnitt durch den Druckkopf und
- Figur 3: ein Ausführungsbeispiel einer erfindungsgemäßen Druckvorrichtung mit dem Druckkopf gemäß den Figuren 1 und 2.

Die Figuren zeigen schematische, nicht maßstabsgetreue Darstellungen. In den Figuren bezeichnen gleiche Bezugselemente gleiche oder gleichwirkende Elemente.

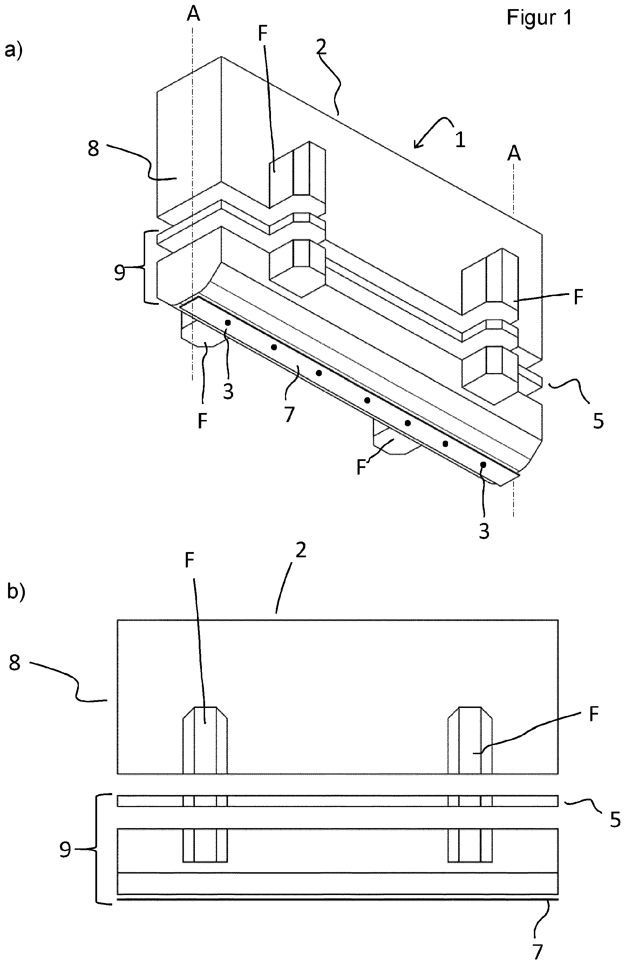

In Figur 1 ist ein Ausführungsbeispiel eines erfindungsgemäßen Druckkopfes 1 in perspektivischer Darstellung (Figur 1a) sowie in Seitenansicht (Figur 1b) dargestellt. Zur besseren Übersicht der einzelnen Komponenten ist der Druckkopf in Explosionsdarstellung gezeigt.

Der Druckkopf 1 weist einen an der Oberseite mittig liegenden Druckmediumeingang 2 auf, um dem Druckkopf 1 Druckmedium zuzuführen. Der Druckmediumeingang 2 ist fluidleitend mit einer Mehrzahl von Ausgabeöffnungen 3 verbunden.

Aus Gründen der besseren Darstellbarkeit sind lediglich wenige Ausgabeöffnungen dargestellt. Die Ausgabeöffnungen sind entlang einer geraden Linie angeordnet und weisen vorliegend jeweils eine kreisförmige Öffnung mit einem Durchmesser im Bereich von 5µm bis 500µm, vorliegend 25 µm und einem Abstand im Bereich 0,5mm bis 5mm, vorliegend 1,2mm auf. Bei diesem Ausführungsbeispiel sind 130 Ausgabeöffnungen vorgesehen, die jedoch - wie zuvor beschrieben - aus Gründen der Darstellbarkeit nicht vollzählig gezeigt sind. Exemplarisch sind die randständigen Ausgabeöffnungen mit dem Bezugszeichen 3 versehen. Das vorliegende Ausführungsbeispiel ist für die Verwendung mit Silberpaste zum Erzeugen von metallischen Kontaktierungsstrukturen einer photovoltaischen Solarzelle geeignet. Bei Verwendung anderer Druckmedien können andere Dimensionierungen, insbesondere der Geometrie des Druckkopfes, der Ausgabeöffnungen, ebenso der Maschengrößen der Filter vorteilhaft sein.

Der Druckkopf weist eine Basiseinheit 8 mit dem Druckmediumeingang 2 und eine Ausgabeeinheit 9 mit einem Lochplatte 7 auf, in welcher die Ausgabeöffnungen 3 ausgebildet sind.

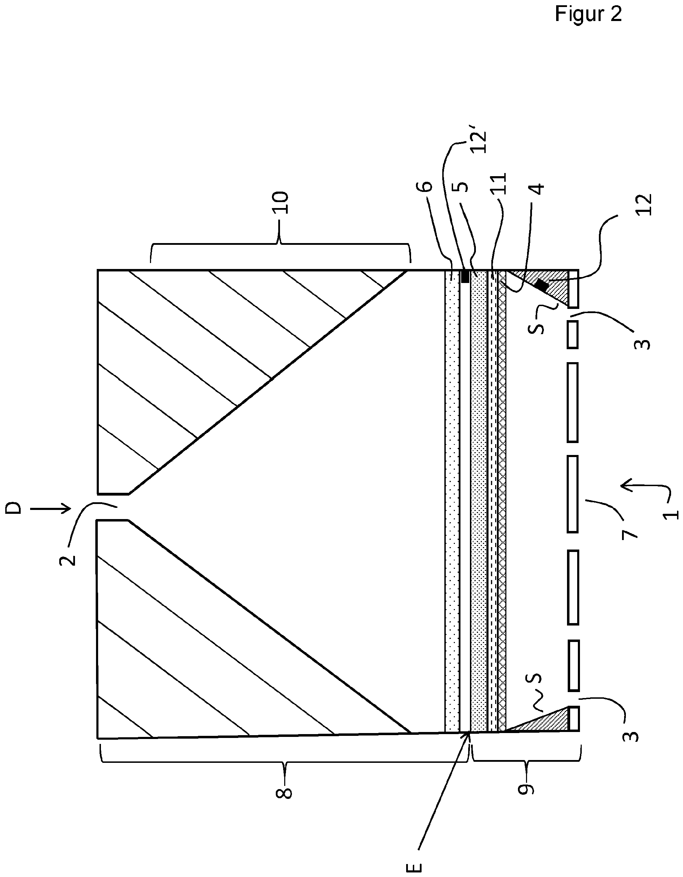

In Figur 2 ist eine Schnittdarstellung eines mittigen Schnitts durch den Drucckopf, sodass die Schnittebene somit parallel zur Zeichenebene gemäß der Darstellung in Figur 1b liegt und die gestrichelten Linien A gemäß der Darstellung Figur 1a enthält.

Wie in Figur 2 ersichtlich, weist die Basiseinheit 8 ein Aufweitungselement 10 auf. In Flussrichtung D des Druckmediums verbreitert sich der Durchflussquerschnitt durch das Aufweitungselement, sodass am unteren Ende E der Basiseinheit 8 ein Durchflussquerschnitt mit einer Länge L parallel zur Zeichenebene gemäß Figur 2 von vorliegend 160 mm und einer Breite B senkrecht zur Zeichenebene in Figur 2 von vorliegend 4 mm und somit ein Aspektverhältnis von 40:1 vorliegt.

Der Durchflussquerschnitt ist somit in Flussrichtung des Druckmediums auf ein Aspektverhältnis größer 5:1 durch das Aufweitungselement aufgeweitet.

Die Ausgabeeinheit 9 ist lösbar an der Basiseinheit 8 angeordnet, vorliegend mittels nicht dargestellter Schrauben, welche in Gewindebohrungen in den Fortsätzen F (in den Figuren 1a und 1b ersichtlich) eingreifen.

Die Ausgabeeinheit 9 weist die Lochplatte 7 mit der Mehrzahl von Ausgabeöffnungen und dem Ausgabefilter 4 auf, welcher mittels Fügeverbindung innerhalb der Ausgabeeinheit 9 angeordnet ist. Bei an der Basiseinheit 8 angeordneter Ausgabeeinheit liegt der Ausgabefilter somit im Flussweg des Druckmediums zwischen Druckmediumeingang 2 und den Ausgabeöffnungen 3.

Mittels des Ausgabefilters 4, welcher vorliegend eine Maschengröße von 5 µm aufweist, kann somit das Eindringen von Partikeln größer dieser Maschengröße in dem Bereich zwischen Ausgabefilter 4 und Lochplatte 7 der Ausgabeeinheit 9 vermieden werden und somit das Risiko, dass die Ausgabeöffnungen 3 während des Druckvorgangs durch Partikel verschlossen werden, erheblich verringert werden.

Weiterhin wird herstellerseitig in einer schmutzfreien Umgebung die Lochplatte 7 und auch der Ausgabefilter 4 mittels Fügeverbindung an der Ausgabeeinheit 9 angeordnet. Hierdurch ist gewährleistet, dass durch den Benutzer kein Öffnen des Bereichs zwischen Lochplatte 7 und Ausgabefilter 4 erfolgt und somit das Eindringen größerer Schmutzpartikel in diesem Bereich vermieden oder zumindest ein solches Risiko erheblich verringert wird. Ebenso ist in einer alternativen Ausbildung eine Anordnung mittels Klemmen oder Schrauben möglich.

Sollte im Rahmen von Wartungsarbeiten dennoch ein Austausch des Ausgabefilters 4 oder der Lochplatte 7 notwendig sein, so kann der Benutzer in einfacher Weise die Ausgabeeinheit 9 von der Basiseinheit 8 lösen und lediglich die Ausgabeeinheit austauschen.

Der Druckkopf 1 weist weiterhin einen Basisfilter 6 auf. Dieser ist, wie in Figur 2 ersichtlich, innerhalb der Basiseinheit 8 angeordnet, sodass im Betriebszustand, bei an der Basiseinheit 8 angeordneter Ausgabeeinheit 9 der Basisfilter im Flussweg des Druckmediums zwischen Druckmediumeingang 2 und Ausgabefilter 4 angeordnet ist. Die Maschengröße des Basisfilters ist größer als die Maschengröße des Ausgabefilters, vorliegend werden etwa 5 µm verwendet.

Wie in Figur 2 ersichtlich, ist der Basisfilter 6 im aufgeweiteten Bereich des Aufweitungselementes 10 angeordnet.

Die Ausgabeeinheit 9 weist seitliche Schrägen S auf, sodass sich der Durchflussquerschnitt in Flussrichtung des Druckmediums zwischen Ausgabefilter 4 und Lochplatte 7 verringert. Hierdurch ergibt sich der Vorteil, dass die Filterfläche maximal ist und gleichzeitig eine gute Montierbarkeit sichergestellt wird.

Der Druckkopf 1 weist weiterhin einen Vorfilter 5 auf. Dieser ist ebenfalls mittels Fügeverbindung am oberen Ende an der Ausgabeeinheit 9 angeordnet, sodass im Betriebszustand der Vorfilter 5 im Flussweg des Druckmediums vor dem Ausgabefilter 4 angeordnet ist.

Der Vorfilter weist vorliegend eine größere Maschengröße als der Ausgabefilter auf, nämlich 10µm. Hierdurch ergibt sich der Vorteil, dass sowohl der Druckverlust, als auch die Wahrscheinlichkeit einer Zusetzung am Ausgabefilter minimiert wird.

Der Vorfilter 5 ist beabstandet zu dem Ausgabefilter 4 angeordnet, sodass sich ein Expansionsraum 11 in der Ausgabeeinheit 9 zwischen Vorfilter 5 und Ausgabefilter 4 ergibt. Dies weist den Vorteil auf, dass ein lateraler Druckausgleich in der Paste stattfinden kann, was insb. bei Teilzusetzung einzelner Maschen wichtig ist.

In Flussrichtung des Druckmediums beträgt der Abstand des Vorfilters 5 zu dem Ausgabefilter 4 vorliegend 1mm.

Der Druckkopf 1 weist weiterhin einen Drucksensor 12 als ersten Drucksensor auf, welcher an einer der Schrägen der Ausgabeeinheit 9 und somit im Bereich zwischen Ausgabefilter 4 und Lochplatte 7 angeordnet ist.

Mittels des Drucksensors 12 kann somit der Druck des Druckmediums unmittelbar vor Ausgabe des Druckmediums durch die Ausgabeöffnungen 3 gemessen werden. Weiterhin weist der Druckkopf 1 einen zweiten Drucksensor 12' auf, welcher in Flussrichtung des Druckmediums vor dem Ausgabefilter 4 angeordnet ist. Über eine Druckdifferenz zwischen zweitem Sensor 12' und erstem Sensor 12 wird der Verschmutzungsgrad des Ausgabefilters 4 mittels einer Auswerteeinheit ermittelt.

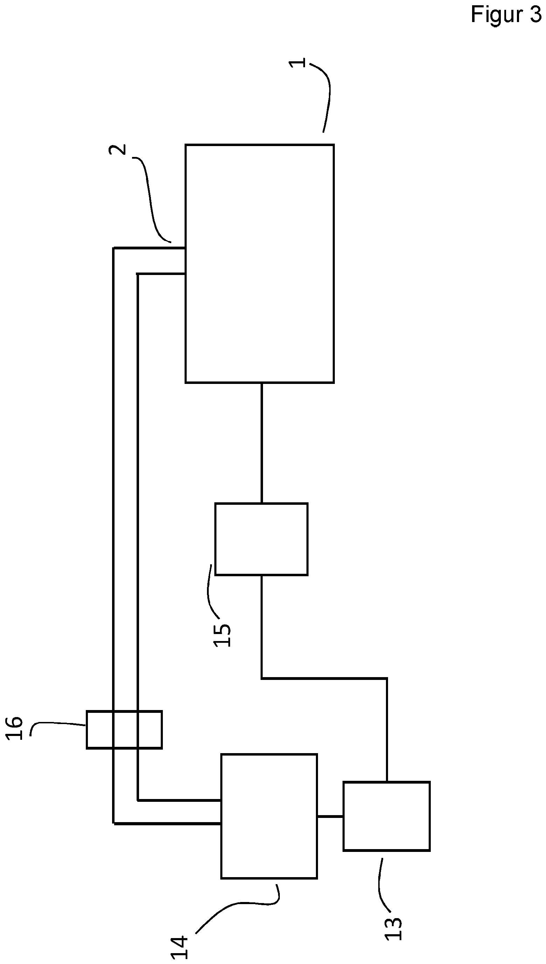

In Figur 3 ist ein Ausführungsbeispiel einer erfindungsgemäßen Druckvorrichtung zum Parallelextrudieren von Druckmedium schematisch dargestellt. Die Druckvorrichtung weist einen Druckkopf 1 gemäß dem zuvor beschriebenen ersten Ausführungsbeispiel auf, eine im Flussweg des Druckmediums stromaufwärts des Druckkopfes angeordnete Druckmediumpumpe 13, um Druckmedium zu dem Druckkopf 1 zu fördern. Die Druckmediumpumpe 13 ist vorliegend als mit einem motorisch betriebenen Kolben ausgebildet, welcher auf ein Druckreservoir 14 einwirkt, um Druckmedium aus dem Druckreservoir 14 zu dem Drucckopf 1 zu fördern.

Die Druckvorrichtung weist weiterhin eine Steuereinheit 15 für die Druckmediumpumpe 13 auf, welche mit dem Drucksensor 12 der Ausgabeeinheit 9 des Druckkopfes 1 zusammenwirkend ausgebildet ist, um die Druckmediumpumpe 13 derart zu regeln, dass während des Druckvorgangs ein konstanter Druck am Drucksensor und somit unmittelbar im Flussweg des Druckmediums vor Erreichen der Lochplatte 7 anliegt.

Hierdurch kann ein Druck mit einer konstanten Linienbreite und Linienhöhe gewährleistet werden.

Für einen Druckvorgang wird ein Substrat unterhalb des Druckkopfes 1 senkrecht zur Zeichenebene relativ zu dem Druckkopf 1 bewegt, sodass auf dem Druckkopf 1 mehrere parallele Druckmediumlinien aufgebracht werden.

Die Druckvorrichtung weist weiterhin einen Eingangsfilter 16 auf, welcher im Flussweg des Druckmediums vor dem Druckkopf 1, vorliegend zwischen Druckmediumreservoir 14 und Druckkopf 1 angeordnet ist. Hierdurch ergibt sich der Vorteil, dassdie Pumpe direkt auf das Medium wirken kann. Der Eingangsfilter 16 weist vorliegend eine Maschengröße von 200µm auf, welche größer als die Maschengröße des Ausgabefilters ist.

### Bezugszeichenliste

- 1: Druckkopf
- 2: Druckmediumeingang
- 3: Ausgabeöffnung
- 4: Ausgabefilter
- 5: Vorfilter
- 6: Basisfilter
- 7: Lochplatte
- 8: Basiseinheit
- 9: Ausgabeeinheit
- 10: Aufweitungselement
- 11: Expansionsraum
- 12: Drucksensor
- 13: Druckmediumpumpe
- 14: Druckmediumreservoir
- 15: Steuereinheit
- 16: Eingangsfilter

## Patentansprüche

1. Druckkopf (1) zum Parallelextrudieren von Druckmedium, insbesondere zur Herstellung von Leiterbahnen, mit einem Druckmediumeingang für das Druckmedium, welcher fluidleitend mit einer Mehrzahl von Ausgabeöffnungen des Druckkopfes verbunden ist, zur gleichzeitigen Ausgabe von Druckmedium aus den Ausgabeöffnungen und mit einem Aufweitungselement, welches im Flussweg des Druckmediums zwischen Druckmediumeingang (2) und Ausgabeöffnungen angeordnet ist, um den Durchflussquerschnitt in Flussrichtung des Druckmediums auf ein Aspektverhältnis von zumindest 3:1 aufzuweiten,
wobei der Druckkopf (1) eine Basiseinheit (8) mit dem Druckmediumeingang (2) und dem Aufweitungselement (10) und eine lösbar an der Basiseinheit (8) angeordnete Ausgabeeinheit (9) aufweist,
wobei die Ausgabeeinheit (9) die Mehrzahl von Ausgabeöffnungen und zumindest einen Ausgabefilter (4) für das Druckmedium aufweist, wobei im Betriebszustand bei an der Basiseinheit (8) angeordneter Ausgabeeinheit (9) der Ausgabefilter (4) im Flussweg des Druckmediums zwischen Druckmediumeingang (2) und Ausgabeöffnungen angeordnet ist,
**dadurch gekennzeichnet, dass** der Druckkopf (1) einen Basisfilter (6) und/oder einen Vorfilter aufweist, wobei der Basisfilter derart an Basiseinheit (8) angeordnet ist, dass im Betriebszustand der Basisfilter (6) im Flussweg des Druckmediums zwischen Druckmediumeingang (2) und Ausgabefilter (4) angeordnet ist,
wobei der Vorfilter derart an der Ausgabeeinheit (9) angeordnet ist, dass im Betriebszustand der Vorfilter (5) im Flussweg des Druckmediums vor dem Ausgabefilter (4) angeordnet ist.

2. Druckkopf (1) nach Anspruch 1,
**dadurch gekennzeichnet,**
**dass** der Ausgabefilter (4) eine mittlere Maschengröße aufweist, welche kleiner als die Hälfte des mittleren Durchmessers der Ausgabeöffnungen ist.

3. Druckkopf (1) nach einem der vorangegangenen Ansprüche,
**dadurch gekennzeichnet,**
**dass** der Ausgabefilter (4) an der Ausgabeeinheit (9) fixiert ist.

4. Druckkopf (1) nach einem der vorangegangenen Ansprüche,
**dadurch gekennzeichnet,**
**dass** die Maschengröße des Basisfilters größer als die Maschengröße des Ausgabefilters ist.

5. Druckkopf (1) nach einem der vorangegangenen Ansprüche,
**dadurch gekennzeichnet,**
**dass** der Basisfilter (6) im aufgeweiteten Bereich des Aufweitungselementes angeordnet ist.

6. Druckkopf (1) nach einem der vorangegangenen Ansprüche,
**dadurch gekennzeichnet,**
**dass** die Ausgabeeinheit (9) derart ausgebildet ist, dass sich der Durchflussquerschnitt in Flussrichtung des Druckmediums zwischen Ausgabefilter (4) und Ausgabeöffnungen verringert.

7. Druckkopf (1) nach einem der vorangegangenen Ansprüche,
**dadurch gekennzeichnet,**
**dass** der Ausgabefilter (4) eine kleinere Maschengröße als der Vorfilter (5) aufweist.

8. Druckkopf (1) nach einem der vorangegangenen Ansprüche,
**dadurch gekennzeichnet,**
**dass** der Vorfilter (5) zum Ausgabefilter (4) beabstandet ist.

9. Druckkopf (1) nach einem der vorangegangenen Ansprüche,
**dadurch gekennzeichnet,**
**dass** der Druckkopf (1) einen Drucksensor (12) für das Druckmedium aufweist, welcher im Flussweg des Druckmediums stromabwärts des Ausgabefilters angeordnet ist.

10. Druckvorrichtung zum Parallelextrudieren von Druckmedium,
mit einem Druckkopf (1) nach einem der vorangegangenen Ansprüche, einer im Flussweg des Druckmediums stromaufwärts des Druckkopfes angeordneten Druckmediumpumpe (13), um Druckmedium aus einem Druckmediumreservoir (14) zu dem Druckkopf (1) zu fördern.

11. Druckvorrichtung nach Anspruch 10,
**dadurch gekennzeichnet,**
**dass** der Druckkopf (1) einen Drucksensor (12) gemäß Anspruch 9 aufweist,
**dass** die Druckvorrichtung eine Steuereinheit (15) für die Druckmediumpumpe (13) aufweist, welche mit dem Drucksensor (12) zusammenwirkend ausgebildet ist, um die Druckmediumpumpe (13) abhängig von den Daten des Drucksensors (12) zu regeln.

12. Druckvorrichtung nach einem der vorangegangenen Ansprüche,
**dadurch gekennzeichnet,**
**dass** die Druckvorrichtung einen Eingangsfilter (16) aufweist, welcher im Flussweg des Druckmediums vor dem Druckkopf (1) angeordnet ist.

13. Verfahren zur Herstellung eines Druckkopfes, insbesondere gemäß einem der Ansprüche 1 bis 9,
mit einer Basiseinheit (8),
wobei die Basiseinheit (8) mit einem Druckmediumeingang (2) für das Druckmedium ausgebildet wird, welcher fluidleitend mit einer Mehrzahl von Ausgabeöffnungen des Druckkopfes verbunden ist, zur gleichzeitigen Ausgabe von Druckmedium aus den Ausgabeöffnungen und die Basiseinheit (8) mit einem Aufweitungselement (10) ausgebildet wird, welches im Flussweg des Druckmediums zwischen Druckmediumeingang (2) und Ausgabeöffnungen angeordnet ist, um den Durchflussquerschnitt in Flussrichtung des Druckmediums auf ein Aspektverhältnis von zumindest 5:1 aufzuweiten,
wobei der Druckkopf mit einer lösbar an der Basiseinheit (8) anordenbaren Ausgebeinheit ausgebildet wird, und wobei ein Ausgabefilter (4) an der Ausgabeeinheit (9) im Flussweg des Druckmediums vor den Ausgabeöffnungen fixiert wird , **dadurch gekennzeichnet,**
**dass** ein Basisfilter (6) an der Basiseinheit (8) und/oder dass ein Vorfilter (5) an der Ausgabeeinheit (9) angeordnet wird,
wobei der Basisfilter derart an der Basiseinheit angeordnet wird, dass im Betriebszustand der Basisfilter (6) im Flussweg des Druckmediums zwischen Druckmediumeingang (2) und Ausgabefilter (4) angeordnet ist, wobei der Vorfilter derart an der Ausgabeeinheit angeordnet wird, dass im Betriebszustand der Vorfilter (5) im Flussweg des Druckmediums vor dem Ausgabefilter (4) angeordnet ist.

14. Verfahren nach Anspruch 13,
**dadurch gekennzeichnet,**
**dass** die Ausgabeöffnungen mittels einem lösbaren Schutzelement, insbesondere einer Schutzfolie, verschlossen werden.

15. Verfahren nach einem der Ansprüche 13 bis 14,
**dadurch gekennzeichnet,**
**dass** die Ausgabeöffnungen in einer Düsenschiene ausgebildet werden und die Düsenschiene mit den Ausgabeöffnungen an der Ausgabeeinheit (9) fixiert wird.

## Claims

1. Print head (1) for parallel extrusion of printing medium, especially for the production of conductor tracks,
having a printing medium inlet for the printing medium, which inlet is in fluid-conducting communication with a plurality of discharge openings of the print head, for simultaneous discharge of printing medium from the discharge openings, and having an expansion element which is arranged in the flow path of the printing medium between printing medium inlet (2) and discharge openings in order to expand the flow cross-section in the flow direction of the printing medium to an aspect ratio of at least 3:1,
wherein the print head (1) has a base unit (8) having the printing medium inlet (2) and the expansion element (10), and a discharge unit (9) which is detachably arranged on the base unit (8), the discharge unit (9) having the plurality of discharge openings and at least one discharge filter (4) for the printing medium, wherein in the operating state, with the discharge unit (9) arranged on the base unit (8), the discharge filter (4) is arranged in the flow path of the printing medium between printing medium inlet (2) and discharge openings,
**characterised in that**
the print head (1) has a base filter (6) and/or a pre-filter, the base filter being arranged on the base unit (8) in such a way that in the operating state the base filter (6) is arranged in the flow path of the printing medium between printing medium inlet (2) and discharge filter (4), the pre-filter being arranged on the discharge unit (9) in such a way that in the operating state the pre-filter (5) is arranged in the flow path of the printing medium before the discharge filter (4).

2. Print head (1) according to claim 1,
**characterised in that**
the discharge filter (4) has an average mesh size that is smaller than half the average diameter of the discharge openings.

3. Print head (1) according to either one of the preceding claims,
**characterised in that**
the discharge filter (4) is fixed to the discharge unit (9).

4. Print head (1) according to any one of the preceding claims,
**characterised in that**
the mesh size of the base filter is larger than the mesh size of the discharge filter.

5. Print head (1) according to any one of the preceding claims,
**characterised in that**
the base filter (6) is arranged in the expanded region of the expansion element.

6. Print head (1) according to any one of the preceding claims,
**characterised in that**
the discharge unit (9) is configured in such a way that the flow cross-section decreases in the flow direction of the printing medium between discharge filter (4) and discharge openings.

7. Print head (1) according to any one of the preceding claims,
**characterised in that**
the discharge filter (4) has a smaller mesh size than the pre-filter (5).

8. Print head (1) according to any one of the preceding claims,
**characterised in that**
the pre-filter (5) is spaced apart from the discharge filter (4).

9. Print head (1) according to any one of the preceding claims,
**characterised in that**
the print head (1) has a pressure sensor (12) for the printing medium, which pressure sensor is arranged in the flow path of the printing medium downstream of the discharge filter.

10. Printing device for parallel extrusion of printing medium,
having a print head (1) according to any one of the preceding claims, a printing medium pump (13) being arranged in the flow path of the printing medium upstream of the print head in order to feed printing medium from a printing medium reservoir (14) to the print head (1).

11. Printing device according to claim 10,
**characterised in that**
the print head (1) has a pressure sensor (12) according to claim 9; the printing device has a control unit (15) for the printing medium pump (13), which control unit is configured to co-operate with the pressure sensor (12) in order to control the printing medium pump (13) in dependence upon the data of the pressure sensor (12).

12. Printing device according to any one of the preceding claims,
**characterised in that**
the printing device has an inlet filter (16) which is arranged in the flow path of the printing medium before the print head (1).

13. Method of producing a print head, especially according to any one of claims 1 to 9,
having a base unit (8),
wherein the base unit (8) is provided with a printing medium inlet (2) for the printing medium, which printing medium inlet is in fluid-conducting communication with a plurality of discharge openings of the print head, for simultaneous discharge of printing medium from the discharge openings, and the base unit (8) is provided with an expansion element (10) which is arranged in the flow path of the printing medium between printing medium inlet (2) and discharge openings in order to expand the flow cross-section in the flow direction of the printing medium to an aspect ratio of at least 5:1, wherein the print head is provided with a discharge unit which is detachably arrangeable on the base unit (8), and wherein a discharge filter (4) is fixed to the discharge unit (9) in the flow path of the printing medium before the discharge openings,
**characterised in that**
a base filter (6) is arranged on the base unit (8) and/or a pre-filter (5) is arranged on the discharge unit (9),
wherein the base filter is arranged on the base unit in such a way that in the operating state the base filter (6) is arranged in the flow path of the printing medium between printing medium inlet (2) and discharge filter (4), the pre-filter being arranged on the discharge unit in such a way that in the operating state the pre-filter (5) is arranged in the flow path of the printing medium before the discharge filter (4).

14. Method according to claim 13,
**characterised in that**
the discharge openings are closed by means of a detachable protective element, especially a protective film.

15. Method according to either one of claims 13 and 14,
**characterised in that**
the discharge openings are formed in a nozzle bar, and the nozzle bar having the discharge openings is fixed to the discharge unit (9).

## Revendications

1. Tête d'impression (1) pour l'extrusion parallèle d'un médium d'impression, en particulier pour la fabrication de pistes conductrices,
comprenant une entrée de médium d'impression pour le médium d'impression, laquelle est en liaison fluidique avec une pluralité d'ouvertures de distribution de la tête d'impression pour la distribution simultanée du médium d'impression à partir des ouvertures de distribution, et comprenant un élément d'élargissement, lequel est disposé dans le chemin d'écoulement du médium d'impression entre l'entrée de médium d'impression (2) et les ouvertures de distribution afin d'élargir la section transversale de passage dans la direction d'écoulement du médium d'impression à un rapport d'aspect d'au moins 3:1,
dans laquelle la tête d'impression (1) présente une unité de base (8) comprenant l'entrée de médium d'impression (2) et l'élément d'élargissement (10) et une unité de distribution (9) disposée de manière détachable sur l'unité de base (8),
dans laquelle l'unité de distribution (9) présente la pluralité d'ouvertures de distribution et au moins un filtre de distribution (4) pour le médium d'impression, dans laquelle dans l'état de fonctionnement, lorsque l'unité de distribution (9) est disposée sur l'unité de base (8), le filtre de distribution (4) est disposé dans le chemin d'écoulement du médium d'impression entre l'entrée de médium d'impression (2) et les ouvertures de distribution,
**caractérisée en ce que**
la tête d'impression (1) présente un filtre de base (6) et/ou un préfiltre,
dans laquelle le filtre de base est disposé sur l'unité de base (8) de telle sorte que dans l'état de fonctionnement le filtre de base (6) soit disposé dans le chemin d'écoulement du médium d'impression entre l'entrée de médium d'impression (2) et le filtre de distribution (4),
dans laquelle le préfiltre est disposé sur l'unité de distribution (9) de telle sorte que dans l'état de fonctionnement le préfiltre (5) soit disposé dans le chemin d'écoulement du médium d'impression avant le filtre de distribution (4).

2. Tête d'impression (1) selon la revendication 1,
**caractérisée en ce**
**que** le filtre de distribution (4) présente une taille de maille moyenne, laquelle est plus petite que la moitié du diamètre moyen des ouvertures de distribution.

3. Tête d'impression (1) selon l'une des revendications précédentes,
**caractérisée en ce**
**que** le filtre de distribution (4) est fixé sur l'unité de distribution (9).

4. Tête d'impression (1) selon l'une des revendications précédentes,
**caractérisée en ce**
**que** la taille de maille du filtre de base est plus grande que la taille de maille du filtre de distribution.

5. Tête d'impression (1) selon l'une des revendications précédentes,
**caractérisée en ce**
**que** le filtre de base (6) est disposé dans la zone élargie de l'élément d'élargissement.

6. Tête d'impression (1) selon l'une des revendications précédentes,
**caractérisée en ce**
**que** l'unité de distribution (9) est réalisée de telle sorte que la section transversale de passage diminue dans la direction d'écoulement du médium d'impression entre le filtre de distribution (4) et les ouvertures de distribution.

7. Tête d'impression (1) selon l'une des revendications précédentes,
**caractérisée en ce**
**que** le filtre de distribution (4) présente une taille de maille plus petite que le préfiltre (5).

8. Tête d'impression (1) selon l'une des revendications précédentes,
**caractérisée en ce**
**que** le préfiltre (5) est distant du filtre de distribution (4).

9. Tête d'impression (1) selon l'une des revendications précédentes,
**caractérisée en ce**
**que** la tête d'impression (1) présente un capteur d'impression (12) pour le médium d'impression, lequel est disposé dans le chemin d'écoulement du médium d'impression en aval du filtre de distribution.

10. Dispositif d'impression pour l'extrusion parallèle du médium d'impression,
comprenant une tête d'impression (1) selon l'une des revendications précédentes, une pompe à médium d'impression (13) disposée dans le chemin d'écoulement du médium d'impression en amont de la tête d'impression afin d'acheminer le médium d'impression d'un réservoir de médium d'impression (14) à la tête d'impression (1).

11. Dispositif d'impression selon la revendication 10,
**caractérisé en ce**
**que** la tête d'impression (1) présente un capteur d'impression (12) selon la revendication 9,
**que** le dispositif d'impression présente une unité de commande (15) pour la pompe à médium d'impression (13), laquelle est réalisée de manière à coopérer avec le capteur d'impression (12) afin de réguler la pompe à médium d'impression (13) en fonction des données du capteur d'impression (12).

12. Dispositif d'impression selon l'une des revendications précédentes,
**caractérisé en ce**
**que** le dispositif d'impression présente un filtre d'entrée (16), lequel est disposé dans le chemin d'écoulement du médium d'impression avant la tête d'impression (1).

13. Procédé pour la fabrication d'une tête d'impression, en particulier selon l'une des revendications 1 à 9,
comprenant une unité de base (8),
dans lequel l'unité de base (8) est réalisée avec une entrée de médium d'impression (2) pour le médium d'impression, laquelle est en liaison fluidique avec une pluralité d'ouvertures de distribution de la tête d'impression pour la distribution simultanée du médium d'impression à partir des ouvertures de distribution et l'unité de base (8) est réalisée avec un élément d'élargissement (10), lequel est disposé dans le chemin d'écoulement du médium d'impression entre l'entrée de médium d'impression (2) et les ouvertures de distribution afin d'élargir la section transversale de passage dans la direction d'écoulement du médium d'impression à un rapport d'aspect d'au moins 5:1,
dans lequel la tête d'impression est réalisée avec une unité de distribution pouvant être disposée de manière détachable sur l'unité de base (8),
et dans lequel
un filtre de distribution (4) est fixé sur l'unité de distribution (9) dans le chemin d'écoulement du médium d'impression avant les ouvertures de distribution,
**caractérisé en ce**
**qu'**un filtre de base (6) est disposé sur l'unité de base (8) et/ou qu'un préfiltre (5) est disposé sur l'unité de distribution (9),
dans lequel le filtre de base est disposé sur l'unité de base de telle sorte que dans l'état de fonctionnement le filtre de base (6) soit disposé dans le chemin d'écoulement du médium d'impression entre l'entrée de médium d'impression (2) et le filtre de distribution (4), dans lequel le préfiltre est disposé sur l'unité de distribution de telle sorte que dans l'état de fonctionnement le préfiltre (5) soit disposé dans le chemin d'écoulement du médium d'impression avant le filtre de distribution (4).

14. Procédé selon la revendication 13,
**caractérisé en ce**
**que** les ouvertures de distribution sont fermées au moyen d'un élément protecteur détachable, en particulier un film protecteur.

15. Procédé selon l'une des revendications 13 à 14,
**caractérisé en ce**
**que** les ouvertures de distribution sont réalisées dans un rail de buses et le rail de buses est fixé avec les ouvertures de distribution sur l'unité de distribution (9).
